(19) Europäisches Patentamt
European Patent Office
Office européen des brevets

(11) **EP 2 894 670 A2**

(12) **EUROPEAN PATENT APPLICATION**

(43) Date of publication:
**15.07.2015 Bulletin 2015/29**

(51) Int Cl.:
*H01L 27/092* (2006.01)     *G11C 17/16* (2006.01)
*H01L 23/525* (2006.01)     *H01L 27/112* (2006.01)

(21) Application number: **14004262.3**

(22) Date of filing: **17.12.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **08.01.2014 US 201414150245**

(71) Applicant: **Broadcom Corporation**
**Irvine, CA 92617 (US)**

(72) Inventors:
• **Ponoth, Shom**
**Newport Beach, CA 92658 (US)**

• **Park, Changyok**
**Irvine, CA 92620 (US)**
• **Lee, Jian-Hung**
**San Jose, CA 95126 (US)**
• **Lu, Chao-Yang**
**Sunnyvale, CA 94087 (US)**
• **Shiau, Guang-Jye**
**Irvine, CA 92612 (US)**

(74) Representative: **Jehle, Volker Armin**
**Bosch Jehle Patentanwaltsgesellschaft mbH
Flüggenstrasse 13
80639 München (DE)**

(54) **One-time programmable memory device comprising a fin structure**

(57)     A field-effect transistor (FET) based one-time programmable (OTP) device is discussed. The OTP device includes a fin structure, a gate structure, a first contact region, and a second contact region. The first contact region includes an insulating region and a conductive region and is configured to be electrically isolated from the gate structure. The second contact region includes the conductive region and is configured to be electrically coupled to at least a portion of the gate structure. The OTP device is configured to be programmed by disintegration of the insulating region in response to a first voltage being applied to the first contact and a second voltage being applied to the second contact region simultaneously, where the second voltage is higher than the first voltage by a threshold value.

FIG. 2

EP 2 894 670 A2

## Description

BACKGROUND OF THE DISCLOSURE

Field of the Disclosure

The present disclosure relates generally to a semiconductor device, including a semiconductor device that is configured and arranged as a one-time programmable (OTP) device.

Background Art

In the field of data storage, there are two general types of storage devices. The first type is volatile memory in which stored information is lost when power is removed. The second type is non-volatile memory in which the information is preserved after the power is removed. There are a few different non-volatile memory technologies in the market today. The main ones include mask read only memory (ROM), floating gate, electrical fuse, and antifuse among others. Certain programmable logic devices (PLDs), such as structured application specific integrated circuits (ASICs) to provide an example, use antifuse technology to configure logic circuits to create a customized integrated circuit (IC) from a standard IC design.

An antifuse is an electrical device that changes from a high resistance to an electrically conductive path. The antifuse represents a one time programmable (OTP) device, namely the change from the high resistance to the electrically conductive path in the antifuse is permanent and irreversible. The programming typically involves applying a programming voltage that exceeds a certain specified voltage to the antifuse to essentially "blow" the antifuse to form the electrically conductive path.

## BRIEF SUMMARY OF THE INVENTION

According to an aspect, a one-time programmable (OTP) device is provided, comprising:

a first dielectric region in substantial contact with a substrate;
a gate structure in substantial contact with the first dielectric region;
a first contact region, in substantial contact with the gate structure, configured to be electrically isolated from the gate structure, the first contact region including:

an insulating region, and
a conductive region; and

a second contact region, in substantial contact with the gate structure, configured to be electrically coupled to at least a portion of the gate structure, the second contact region including the conductive region.

Advantageously, the OTP device further comprises:

a fin structure in substantial contact with the substrate, the fin structure comprising a source region and a drain region.

Advantageously, the OTP device further comprises:

a third contact region arranged to wrap around at least a first portion of the fin structure; and
a fourth contact region arranged to wrap around at least a second portion of the fin structure.

Advantageously, the gate structure is between the source region and the drain region and arranged to wrap around at least a portion of the fin structure.

Advantageously, the first contact region is in substantial contact with a first region of the gate structure;

wherein the second contact region is in substantial contact with a second region of the gate structure; and
wherein the first and second regions are separated by the fin structure.

Advantageously, the insulating region is in substantial contact with the gate structure; and

wherein the conductive region is in substantial contact with the insulating region.

Advantageously, the first contact comprises a cross-section having an outer region and an inner region, wherein the outer region includes the insulating region and the inner region includes the conductive region.

Advantageously, the OTP device further comprises:

a second dielectric region in substantial contact with the first dielectric region; and
a third dielectric region in substantial contact with the second dielectric region.

Advantageously, the first contact comprises a cross-section having a first side and a second side, the first side being in substantial contact with the gate structure and the second side being in substantial contact with the third dielectric region.

Advantageously, the second contact region comprises a cross-section having a first side and a second side, the first side being in substantial contact with the gate structure and the second side being in substantial contact with the third dielectric region.

Advantageously, the insulating region comprises a dielectric material.

Advantageously, the insulating region is configured to disintegrate in response to a first voltage being applied to the first contact and a second voltage applied to the second contact region simultaneously, the second voltage being higher than the first voltage by a threshold value.

Advantageously, the second contact region comprises a cross-section having an insulating side, the insulating side being configured to be disintegrated in response to a first voltage applied to the first contact and a second voltage applied to the second contact region simultaneously, the second voltage being higher than the first voltage by a threshold value.

Advantageously, the OTP device is configured to be programmed in response to a first voltage being applied to the first contact and a second voltage being applied to the second contact region simultaneously, the second voltage being higher than the first voltage by a threshold value.

According to an aspect, a method is provided of fabricating a one-time programmable device, comprising:

forming in substantial contact with a gate structure; forming a first contact in substantial contact with a first region of the gate structure, the first contact including:

an insulating region, and the conductive region;

forming a second contact region in substantial contact with a second region of the gate structure, the second contact region including the conductive region.

Advantageously, the forming of the first contact comprises:

forming a trench in a first dielectric region and a second dielectric region, the first dielectric region being disposed in substantial contact with the second dielectric region and the second dielectric being disposed in substantial contact with the gate structure; disposing an insulating region to form an insulating region on sides of the trench; disposing a first conductive region to form a conductive region in substantial contact with the insulating region; and disposing a second conductive region to at least fill the lined trench.

Advantageously, the formed first contact comprises a cross-section having a first side and a second side, the first side being in substantial contact with the gate structure and the second side being in substantial contact with the first dielectric region.

Advantageously, the forming of the second contact region comprises:

forming a trench in a first dielectric region and a second dielectric region, the first dielectric region being disposed in substantial contact with the second dielectric region and the second dielectric being disposed in substantial contact with the gate structure; disposing a first conductive region to form a conductive region on sides of the trench; and disposing a second conductive region to at least fill the lined trench.

Advantageously, the formed second contact region comprises a cross-section having a first side and a second side, the first side being in substantial contact with the gate structure and the second side being in substantial contact with the first dielectric region.

Advantageously, the forming of the first and second is in substantial contact with comprises:

forming a first trench; disposing an insulating region to form an insulating region on sides of the first trench; forming a second trench; disposing a first conductive region to form a conductive region in substantial contact with the insulating region of the first trench and on sides of the second trench; disposing a second conductive region to fill the lined first trench and the lined second trench.

According to an aspect, a semiconductor device comprises:

a source region; a drain region; a gate structure between the source region and the drain region; a first contact region in substantial contact with the gate structure and configured to be electrically isolated from the gate structure, the first contact region including:

an insulating region, and a conductive region; and

a second contact region in substantial contact with the gate structure and configured to be electrically coupled to at least a portion of the gate structure, the second contact region including the conductive region.

Advantageously, the first contact is in substantial contact with a first region of the gate structure; and wherein the second contact region is in substantial contact with a second region of the gate structure.

Advantageously, the semiconductor device is configured to operate as a one-time programmable device.

Advantageously, the semiconductor device is configured to be programmed by applying a first voltage to the first contact and a second voltage to the second contact region to disintegrate the insulating region, the second voltage being higher than the first voltage by a threshold value.

BRIEF DESCRIPTION OF THE DRAWINGS/FIGURES

The accompanying drawings illustrate the present disclosure and, together with the description, further serve to explain the principles of the disclosure and to enable one skilled in the pertinent art to make and use the disclosure.

> FIG. 1 illustrates a block diagram of a memory device;
> FIG. 2 illustrates a schematic of a FET configured as an OTP device;
> FIGs. 3A-E illustrate schematic cross-sectional views along lines A-A, B-B, C-C, D-D, and E-E, respectively, of the OPT device of FIG. 2;
> FIGs. 4A - 12A, 4B - 12B, and 4C - 12C illustrate schematic cross-sectional views along lines A-A, B-B, and C-C, respectively, of the OTP device of FIG. 2 at various stages of its fabrication process;
> FIG. 13 illustrates a flowchart for a method of fabricating the OTP device of FIG. 2.

The present disclosure will now be described with reference to the accompanying drawings. In the drawings, like reference numbers generally indicate identical, functionally similar, and/or structurally similar elements. The drawing in which an element first appears is indicated by the leftmost digit(s) in the reference number.

DETAILED DESCRIPTION OF THE DISCLOSURE

The following Detailed Description refers to accompanying drawings to illustrate one or more embodiments consistent with the present disclosure. The disclosed embodiment(s) merely exemplify the disclosure. The embodiment(s) described, and references in the specification to "one embodiment," "an embodiment," "an example embodiment," "an example of this embodiment," etc., indicate that the embodiment(s) described may include a particular feature, device, or characteristic, but every embodiment may not necessarily include the particular feature, device, or characteristic. Moreover, such phrases are not necessarily referring to the same embodiment. Further, when a particular feature, device, or characteristic is described in connection with an embodiment, it is within the knowledge of those skilled in the relevant art(s) to effect such feature, device, or characteristic in connection with other embodiments whether or not explicitly described.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein may be spatially arranged in any orientation or manner.

The embodiments described herein are provided for illustrative purposes, and are not limiting. Other embodiments are possible, and modifications can be made to the embodiments within the spirit and scope of the present disclosure. Therefore, the Detailed Description is not meant to limit the present disclosure. Rather, the scope of the present disclosure is defined only in accordance with the following claims and their equivalents.

The following Detailed Description of the embodiments will so fully reveal the general nature of the present disclosure that others can, by applying knowledge of those skilled in relevant art(s), readily modify and/or adapt for various applications such embodiments, without undue experimentation, without departing from the spirit and scope of the disclosure. Therefore, such adaptations and modifications are intended to be within the meaning and plurality of equivalents of the embodiments based upon the teaching and guidance presented herein.

It is to be understood that the phraseology or terminology herein is for the purpose of description and not of limitation, such that the terminology or phraseology of the present specification is to be interpreted by those skilled in relevant art(s) in light of the teachings herein.

Those skilled in the relevant art(s) will recognize that this description may be applicable to many various devices, and should not be limited to any particular type of device. Before describing the various embodiments in more detail, further explanation shall be given regarding certain terms that may be used throughout the descriptions.

The term "etch" or "etching" generally describes a fabrication process of patterning a material, such that at least a portion of the material remains after the etch is completed. For example, the process of etching a semiconductor material can involve one or more of: patterning a masking region (e.g., photoresist or a hard mask) over the semiconductor material, subsequently removing areas of the semiconductor material that are not longer protected by the mask region, and optionally removing remaining portions of the mask region. Generally, the removing the areas of the semiconductor material that are not covered by the mask region uses an "etchant" that has a "selectivity" that is higher to the semiconductor material than the mask region. As such, the areas of semiconductor material protected by the mask would remain after the etch process is complete. However, the above is provided for purposes of illustration, and is not limiting. In another example, etching may also refer to a process that does not use a mask, but still leaves behind at least a portion of the material after the etch process is complete.

The above description serves to distinguish the term "etching" from "removing." In an embodiment, when etching a material, at least a portion of the material remains behind after the process is completed. In contrast, when removing a material, substantially all of the material is removed in the process. However, "removing" can incorporate "etching".

The terms "deposit" or "dispose" describe applying a region of material to the substrate. Such terms are meant to describe any possible region-forming technique including, but not limited to, thermal growth, sputtering, evaporation, chemical vapor deposition, atomic region deposition, epitaxial growth, electroplating, etc.

The term "substrate" describes a material which materials are deposited into and/or subsequent material regions are added onto. In embodiments, the substrate itself may be patterned and materials added on top of it may also be patterned, or may remain without patterning. Furthermore, "substrate" may be any of a wide array of semiconductor materials such as silicon, germanium, gallium arsenide, indium phosphide, etc. In other embodiments, the substrate may be electrically non-conductive such as a glass or sapphire wafer.

The term "substantially perpendicular," in reference to a topographical feature's sidewall, generally describes a sidewall disposed at an angle ranging between about 85 degrees and 90 degrees with respect to the substrate.

The term "substantially" or "in substantial contact" generally describes elements or structures in physical substantial contact with each other with only a slight separation from each other which typically results from fabrication and/or misalignment tolerances. It should be understood that relative spatial descriptions between one or more particular features, structures, or characteristics (e.g., "vertically aligned," "substantial contact," etc.) used herein are for purposes of illustration only, and that practical implementations of the structures described herein may include fabrication and/or misalignment tolerances without departing from the spirit and scope of the present disclosure.

In an embodiment, devices fabricated in and/or on the substrate may be in several regions of the substrate, and these regions may not be mutually exclusive. That is, in some embodiments, portions of one or more regions may overlap.

Unless otherwise indicated, the drawings provided throughout the disclosure should not be interpreted as to-scale drawings.

AN EXEMPLARY MEMORY DEVICE

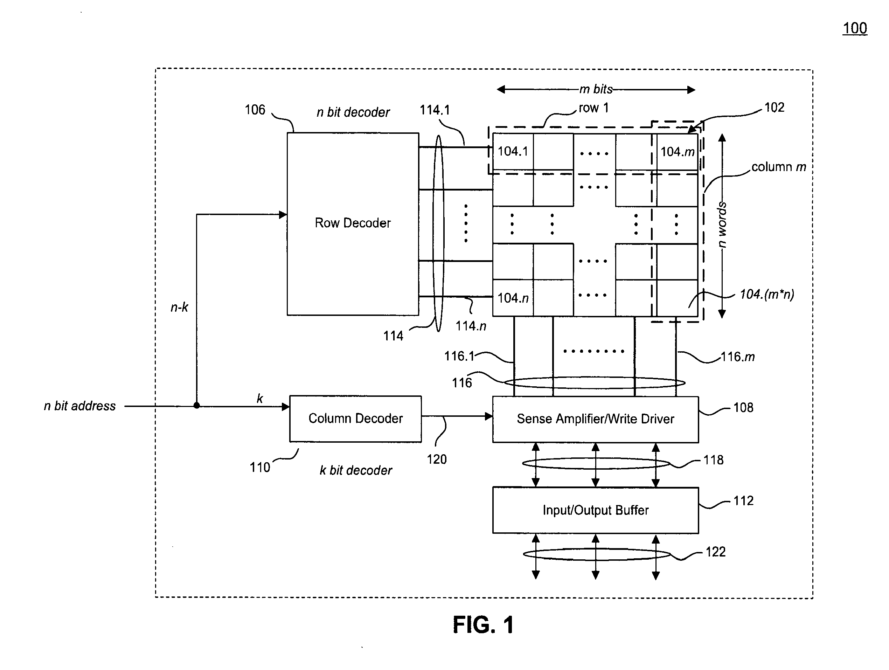

FIG. 1 illustrates a block diagram of a memory device 100 according to an example embodiment. The memory device 100 represents, for example, a non-volatile memory. As such, the memory device 100 can maintain stored electronic data even when not powered. The memory device 100 can operate in a read mode of operation to read electronic data from one or more memory cells, or in a write mode of operation to write electronic data into the one or more memory cells. The memory device 100 can include a memory array 102, a row decoder 106, a sense amplifier 108, a column decoder 110, an input/output (I/O) buffer 112, word lines (WLs) 114.1 through 114.n, and bit lines (BLs) BLs 116.1 through 116.m.

The memory cells 104 can be arranged in an array of n rows and m columns to form memory cells 104.1 through 104.(m*n). However, other arrangements for the memory cells 104.1 through 104.(m*n) are possible without departing from the spirit and scope of the present disclosure. Each of the memory cells 104.1 through 104.(m*n) can be connected to a corresponding WL from among WLs 114.1 through 114.n and a corresponding BL from among BLs 116.1 through 116.m. In an exemplary embodiment, the memory cells 104 in each of the m columns can share a BL from among the BLs 116.1 through 116.m. Similarly, the memory cells 104 in each of n rows of the memory array 102 can share a WL from among WLs 114.1 through 114.n. For example, in FIG. 1, the memory cells 104.1 through 104.m of row 1 can share the WL 114.1 and the memory cells 104.m through 104.(m*n) of column m share BL 116.m.

To select a particular memory cell from among the memory cells 104.1 through 104.(m*n) for a mode of operation, such as the read mode of operation or the write mode of operation to provide some examples, the BL and the WL associated with this particular memory cell can be activated. For example, the BL 116.1 and the WL 114.1 can be activated to select the memory cell 104.1. Thereafter, the electronic data can be written into the particular memory cell in the write mode of operation or the electronic data can be read from the particular memory cell in the read mode of operation upon its selection.

Each of the WLs 114.1 through 114.n can be selectively activated by applying a corresponding n-k bit row address from among a corresponding n bit address to a row decoder 106. The row decoder 106 can decode the corresponding n-k bit row address and can provide one or more control signals to the WLs 114.1 through 114.n that correspond to the n-k bit row address to select a row of memory cells from among the memory cells 104.1 through 104.(m*n) that corresponds to the n-k bit row address. Similarly, each of the BLs 116.1 through 116.m can be selectively activated by applying a corresponding k bit column address from among the corresponding n bit address to a column decoder 110. The column decoder 110 can decode the corresponding k bit column address and can provide one or more control signals 120 to the sense amplifier 108 that correspond to the k bit column address. The sense amplifier 108 selects a column of memory cells from among the memory cells 104.1 through 104.(m*n) that corresponds to the k bit column address.

The sense amplifier 108 can read the electronic data from a memory cell that corresponds to the selected row and column from among the memory cells 104.1 through 104.(m*n) during a read mode operation and provides electronic data 118 to the I/O Buffer 112 in the read mode operation. The I/O Buffer 112 can store the electronic data 118 to provide electronic data 122. Alternatively, the I/O Buffer 112 can receive the electronic data 122 and provide the electronic data 122 as the electronic data 118 in the write mode of operation. Thereafter, the sense amplifier 108 can receive the electronic data 118 from the I/O Buffer 112 and can write this electronic data to the memory cell that corresponds to the selected row and column in the write mode of operation.

<u>EXEMPLARY OTP DEVICE</u>

Memory cells, such as the memory cells 104.1 through 104.(m*n) to provide an example, can each include a non-volatile storage device. This non-volatile storage device can include a semiconductor device, such as an OTP device to provide an example, to store a logical value, such as a logical one or a logical zero. The logical one or zero typically refers to a state of the OTP device. For example, the OTP device in a conducting state may be assigned to correspond to a logical one and in a non-conducting state may be assigned to correspond to a logical zero. This assignment of the logical values to a state of the OTP device can be application specific.

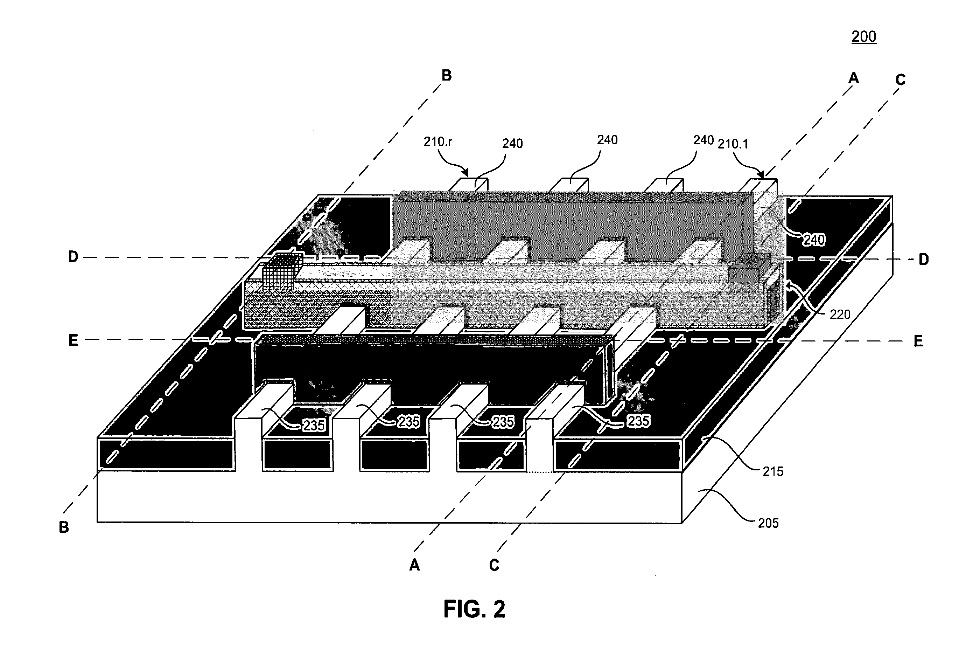

FIG. 2 illustrates an implementation layout for an OTP device 200 according to an embodiment. The OTP device 200 can represent an exemplary embodiment of the non-volatile storage device within one of the memory cells, such as the memory cells 104.1 through 104.(m*n) to provide an example. However, this exemplary embodiment is not limiting, the OTP device 200 can be used in other electronic circuits without departing from the spirit and scope of the present disclosure. The OTP device 200 includes a substrate 205, fin structures 210.1 through 210.r, a shallow trench isolation (STI) region 215, a gate structure 220, a source region 235 and a drain region 240.

The substrate 205 represents a physical material on which the OTP device 200 is formed. The substrate 205 can be a semiconductor material such as, but not limited to, silicon, germanium, gallium arsenide, indium phosphide, or any combination thereof. The substrate 205 can include a p-type material to form a p-type substrate or an n-type material to form an n-type substrate. The p-type material includes impurity atoms of an acceptor type, such as, but not limited to, boron or aluminum to provide some examples, that are capable of accepting an electron. The p-type material causes a carrier hole density in the substrate 205 to exceed a carrier electron density. The n-type material includes impurity atoms of a donor type, such as, but not limited to, phosphorus, arsenic, or antimony to provide some examples, that are capable of donating an electron. The n-type material causes the carrier electron density in the substrate 205 to exceed a carrier hole density.

The fin structures 210.1 through 210.r represent current carrying structures within the substrate 205. It should be noted that the OTP device 200 can include any suitable number of the fin structures 210.1 through 210.r. This suitable number can include a single fin structure 210.1 as well as multiple fin structures 210.1 through 210.r. The fin structures 210.1 through 210.r as illustrated in FIG. 2 are similar in structure, but those skilled in the relevant art(s) will recognize that the fin structures 210.1 through 210.r can each have a distinct fin structure with respect to each other. The fin structures 210.1 through 210.r can include various regions that include the n-type material to form n-type regions and/or the p-type material to form p-type regions. These p-type regions and/or n-type regions represent the source region 235 and/or the drain region 240 for the OTP device 200. It is understood by those skilled in the relevant art(s) that the source region 235 and the drain region 240 can be interchangeable. In an exemplary embodiment, the source region 235 and/or the drain region 240 represent heavily doped regions. Generally, a low or a lightly doped region includes a comparatively small number of atoms, approximately

$$\frac{5x10^{18}}{cm^3} \text{ to } \frac{1x10^{19}}{cm^3} \text{ while a high or heavily doped}$$

region includes a comparatively large number of atoms,

approximately $\dfrac{1x10^{19}}{cm^3}$ to $\dfrac{5x10^{20}}{cm^3}$ .

The STI region 215 to provides isolation and/or protection for the OTP device 200 from neighboring active and passive elements (not illustrated in FIG. 2) integrated with or deposited onto the substrate 205. Additionally, the STI region 215 provides electrical isolation between the fin structures 210.1 through 210.r and/or between the fin structures 210.1 through 210.r and the neighboring active and passive elements. The STI region 215 can include silicon oxide ($SiO_2$), though any suitable insulating material can be used. For example, the STI region 215 can include polysilicon rather than $SiO_2$ in bipolar technologies.

The gate structure 220 can act as a control structure to control the current flowing through the structures 210.1 through 210.r between the source region 235 and/or the drain region 240. The OTP device 200 can be programmed by applying a sufficient potential to the gate structure 220 to disintegrate or "blow" a portion of the gate structure 220. Typically, this disintegration or "blowing" of the portion of the gate structure 220 is irreversible or permanent. When the OTP device 200 is in an programmed state, applying a first potential, such as a positive direct current (DC) voltage to provide an example, to the gate structure 220 and applying a second potential, such as a ground potential to provide an example, to the source region 235 causes a voltage to appear between the gate structure 220 and the source region 235. The first potential on the gate structure 220 repels carriers from a bottom side of the gate structure 220 forming a channel region. The channel region represents a carrier-depletion region populated formed at a bottom side of the gate structure 220 by an electric field. This electric field also attracts carriers from the source region 235 and drain region 240 into the channel region. The channel region eventually connects the source region 235 to the drain region 240 after a sufficient number of carriers have accumulated in the carrier-depletion region allowing a current to pass through the channel region from the drain region 240 to the source region 235. This programmed state of OTP device 200 can be sensed and can correspond to a logical one or zero depending on a specific application. However, when the OTP device 200 is in an unprogrammed state, the portion of the gate structure 220, which was disintegrated in the programmed state, is intact. This portion of the gate structure 220 significantly prevents the formation of the channel region at the bottom side of the gate structure 220. This unprogrammed state of OTP device 200 can be sensed and can correspond to a logical one or zero depending on a specific application.

## FIRST CROSS-SECTIONAL VIEW OF THE EXEMPLARY OTP DEVICE

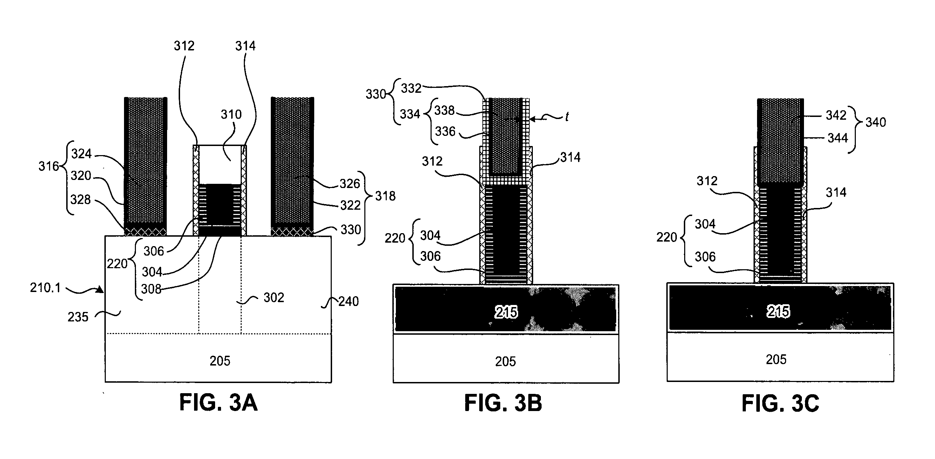

The OTP device 200 is to be further described in conjunction with FIG. 3A through FIG. 3E. FIG. 3A through FIG. 3E further describe the OTP device 200 along various cross-sectional lines, denoted as A-A through E-E in FIG. 2. It should be noted that the exemplary illustration of the OTP device 200 in FIG. 2 and the exemplary illustration of the OTP device 200 along the lines A-A through E-E in FIG. 3A through FIG. 3E may not be to scale. Those skilled in the relevant art(s) will recognize that FIG. 3A through FIG. 3E are intended to describe additional structures of the OTP device 200 as well as further describe those structures of the OTP device 200 that are illustrated in FIG. 2. Those skilled in the relevant art(s) will additionally recognize that the OTP device 200 need not include all of the additional structures of the OTP device 200 as illustrated FIG. 3A through FIG. 3E without departing from the spirit and scope of the present disclosure. Rather, different structures, configurations, and arrangements, as well as different configurations and arrangements for the structures described in FIG. 2 and FIG. 3A through FIG. 3E, are possible for the OTP device 200 without departing from the spirit and scope of the present disclosure.

FIG. 3A illustrates a first cross-sectional view of the OTP device 200 through the substrate 205, the fin structure 210.1, the gate structure 220, the source region 235, and the drain region 240 along line A-A as illustrated in FIG. 2. As illustrated in FIG. 3A, the fin structure 210.1 is in substantial contact with the substrate 205 and includes the source region 235 and the drain region 240 along the line A-A. A channel region 302 can form between the source region 235 and the drain region 240 when a sufficient number of carriers have accumulated in a carrier-depletion region beneath the gate structure 220. In an exemplary embodiment, a region within the fin structure 210.1 upon which the channel region 302 can form can include the p-type material to form a p-type channel region or the n-type material to form an n-type channel region.

As additionally illustrated in FIG. 3A, the gate structure 220 is in substantial contact with the fin structure 210.1 between the source region 235 and the drain region 240 along the line A-A. Typically, the gate structure 220 is located above the fin structure 210.1 where the channel region 302 is to form. The gate structure 220 can include a gate metal region 304, a work function metal and high-k dielectric region 306, and a silicon oxide gate dielectric region 308. The gate dielectric region 308 isolates the gate structure 220 from the fin structure 210 to prevent carriers from flowing through the gate structure 220 when current is flowing from through the channel region 302. The gate dielectric region 308 can include one or more dielectric materials such as thermal oxide, nitride, high-k dielectric, or any combination. While the gate dielectric region 308 is illustrated in the present disclosure as a single region, the gate dielectric region 308 can include a multiple dielectric regions in an alternate embodiment. The gate region 304 is in substantial contact with the metal region 306 while the metal region 306 is in substantial contact with the gate dielectric region 308. The gate region 304 can be, for example, Tunsten , Aluminium or any suitable metal. The work function metal region 306 can be, for example, TiN, TiC, TiAlC among other possible work function metals. The work function metal can be used to adjust the threshold voltage of the transistor. The gate dielectric region 308 is in substantial contact with the fin structure 210.1.

The gate structure 220 can additionally include an optional gate cap region 310, a first spacer region 312, and a second spacer region 314 along the line A-A. The spacer regions 312 and 314 are in substantial contact with the gate region 304, the metal region 306, the gate dielectric region 308, and the optional gate cap region 310. The optional gate cap region 310 can be in substantial contact with the gate region 304. The optional gate cap region 310 can include dielectric materials such as, but not limited to, silicon nitride. The optional gate cap region 310 and the spacer regions 312 and 314 helps to protect the integrity of the gate structure 220 during subsequent processing of the OTP device 200. In addition, the spacer regions 312 and 314 can be used as hard mask during fabrication of the gate structures 220. The gate cap region 310 and the spacer regions 312 and 314 can also be used in a self-aligned contact (SAC) enablement process which may be needed for current and future nodes.

As further illustrated in FIG. 3A, a first contact region 316 is in substantial contact with the fin structure 210.1, above the source region 235 and a second contact structure 318 is in substantial contact with the fin structure 210.1, above the drain region 240 along the line A-A. The first contact region 316 and the second contact region 318 can include conductive material for routing signals to the source region 235 and the drain region 240, respectively. The contact regions 316 and 318 can include conductive regions 320 and 322, conductive regions 324 and 326, and silicide regions 328 and 330, respectively. The silicide region 328 can provide a low resistive uniform interface between the conductive structure 316 and the source region 235, while the silicide region 330 provides a similar interface between the conductive structure 318 and the drain region 240.

SECOND CROSS-SECTIONAL VIEW OF THE EXEMPLARY OTP DEVICE

FIG. 3B illustrates a second cross-sectional view of the OTP device 200 through the substrate 205, the STI region 215, and the gate structure 220 along line B-B as illustrated in FIG. 2. As illustrated in FIG. 3B, the STI region 215 is in substantial contact with the substrate 205 and the gate structure 220 along the line B-B. The gate structure 220 can include the gate region 304 and the metal region 306 along the line B-B. Although not illustrated in FIG. 3B, the gate structure 220 can optionally include the gate dielectric region 308 along the line B-B.

As additionally illustrated in FIG. 3B, a first OTP programming region 330 is in substantial contact with the gate structure 220. The first OTP programming region 330 can be used during programming and reading operation of the OTP device 200. The gate structure 220 does not include the optional gate cap region 310 along the line B-B. Instead, the first OTP programming region 330 is in substantial contact with the gate region 304 and the metal region 306. The first OTP programming region 330 can include an OTP region 332 and a gate contact region 334. The OTP region 332 can include a thickness $t$ ranging from approximately 1nm - approximately 5nm, according to an example of this embodiment. While the OTP region 332 is illustrated in the present disclosure as a single region, in an alternate embodiment the OTP region 332 can include a plurality of dielectric regions. As to be discussed below, the OTP region 332 can be disintegrated or "blown" to program the OTP device 200. When the OTP region 332 is disintegrated or "blown", a low resistance path forms between the OTP region 332 and the gate contact region 334. This low resistance path allows signals to be routed between the gate contact region 334 and the gate structure 220. The gate contact region 334 can include a first conductive region 336 and a second conductive region 338. The conductive regions 336 and 338 can include, materials such as, but not limited to, titanium (Ti), titanium nitride (TiN), Tungsten, Aluminum or any combination thereof. The conductive regions 336 and 338 allow signals to be routed between the gate contact region 334 and the gate structure 220.

THIRD CROSS-SECTIONAL VIEW OF THE EXEMPLARY OTP DEVICE

FIG. 3C illustrates a third cross-sectional view of the OTP device 200 through the substrate 205, the STI region 215, and the gate structure 220 along line C-C as illustrated in FIG. 2. As illustrated in FIG. 3C, the STI region 215 is in substantial contact with the substrate 205 and the gate structure 220 along the line C-C. The gate structure 220 can include the gate region 304 and the metal region 306 along the line C-C. Although not illustrated in FIG. 3C, the gate structure 220 can optionally include the gate dielectric region 308 along the line C-C.

As additionally illustrated in FIG. 3C, a second OTP programming region 340 is in substantial contact with the gate structure 220. The second OTP programming region 340 can be used during programming and reading operation of the OTP device 200. The second OTP programming region 340 can include a first conductive region 342 and a second conductive region 344. The conductive regions 342 and 344 can include, materials such as, but not limited to, titanium (Ti), titanium nitride (TiN), Tungsten, Aluminum or any combination thereof. The conductive regions 342 and 344 allow signals to be routed between the second OTP programming region 340 and the gate structure 220.

FOURTH CROSS-SECTIONAL VIEW OF THE EXEMPLARY OTP DEVICE

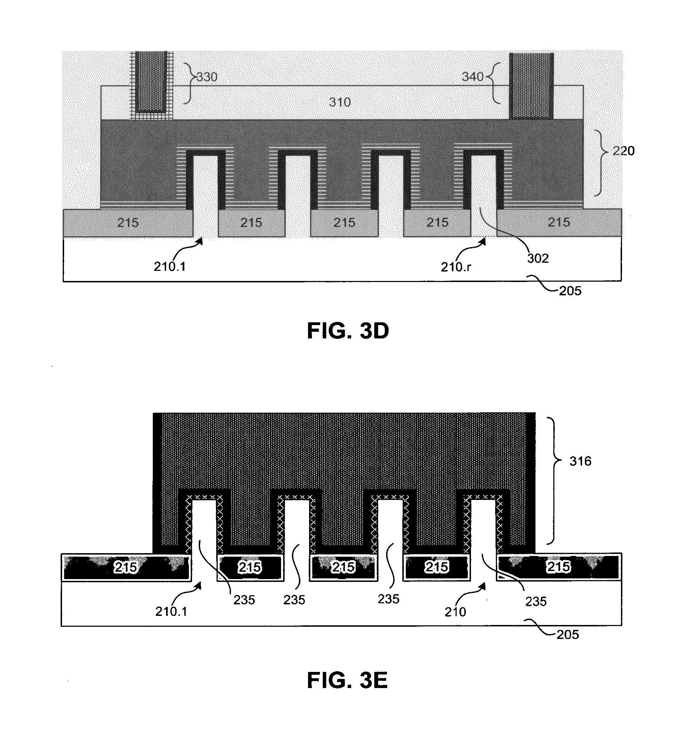

FIG. 3D illustrates a fourth cross-sectional view of the OTP device 200 through the substrate 205, the fin structures 210.1 through 210.r, the STI region 215, the gate structure 220 along line D-D as illustrated in FIG. 2. As illustrated in FIG. 3D, the fin structures 210.1 through 210.r are in substantial contact with the substrate 205 along the line D-D. The channel region 302 can form within each of the of the fin structures 210.1 through 210.r when a sufficient number of carriers have accumulated in the carrier-depletion region beneath the gate structure 220.

As additionally illustrated in FIG. 3D, the optional gate cap region 310 is in substantial contact with the gate structure 220 along the line D-D. The gate structure 220 is also in substantial contact with the first OTP programming region 330 and the second OTP programming region 340 along the line D-D.

FIFTH CROSS-SECTIONAL VIEW OF THE EXEMPLARY OTP DEVICE

FIG. 3E illustrates a fourth cross-sectional view of the OTP device 200 through the substrate 205, the fin structures 210.1 through 210.r, the STI region 215, the gate structure 220 along line E-E as illustrated in FIG. 2. As illustrated in FIG. 3E, the substrate 203 includes the source region 235. The fin structures 210.1 through 210.r are in substantial contact with the source region 235 along the line E-E.

As additionally illustrated in FIG. 3E, the first contact region 316 is in substantial contact with the fin structures 210.1 through 210.r and the STI region 215 along the line E-E. Although not described as such, the second contact region 318, illustrated in FIG. 3A, is in substantial contact with the fin structures 210.1 through 210.r and the STI region 215 in a substantially similar manner as the first contact region 316 along the line E-E.

PROGRAMMING AND READING OF THE EXEMPLARY OTP DEVICE

The OTP device 200 can be programmed by stressing the OTP region 332 of the first OTP programming region 330 on the gate structure 220 beyond a critical electric field to disintegrate or "blow" the OTP region 332. When the OTP region 332 is disintegrated or "blown", the OTP region 332 can be referred to as being in a programmed state. Typically, this disintegration or "blowing" of the OTP region 332 is irreversible or permanent. The critical electric field is a threshold at which disintegration of the OTP region 332 occurs. When the OTP region 332 disintegrates, a resistance between the first OTP programming region 330 and the gate structure 220 is less than a resistance present between first OTP programming region 330 and the gate structure 220 when the OTP region 332 is intact. Such decrease in resistance can occur because disintegration of the OTP region 332 causes a conductive path to be formed between the gate contact region 334 of first OTP programming region 330 and the gate structure 220. The presence of this conductive path can allow the OTP device 200 to operate in a substantially similar manner as a conventional transistor, namely the channel region 302 eventually forms and connects the source region 235 to the drain region 240 after a sufficient number of carriers have accumulated in a carrier-depletion region beneath the gate structure 220 allowing a current to pass through the channel region from the drain region 240 to the source region 235. This operation of the OTP device 200 can be sensed and read as a programmed state of OTP device 200 that can correspond to a logical one or zero based on applications.

However, when the OTP region 332 is not disintegrated or "blown", the resistance between the first OTP programming region 330 and the gate structure 220 is greater. The OTP region 332 is said to be intact and the OTP device 200 can be referred to as being in an unprogrammed state. In the unprogrammed state, the conductive path between the first OTP programming region 330 and the gate structure 220 is not present and the OTP 200 cannot operate in a substantially similar manner as the conventional transistor. The presence of the OTP region 332 significantly prevents the formation of the channel region 302 at the bottom side of the gate structure 220. This unprogrammed state of OTP device 200 can be sensed and can correspond to a logical one or zero depending on a specific application.

During programming of the OTP device 200, stress to OTP region 332 can be provided by applying an electric field larger than the critical electric field across the first OTP programming region 330 and the second programming region 340, according to an example of this embodiment. For example, a programming voltage (e.g. 5V) can be applied at the second programming region 340 and a gate voltage (e.g. 0V) can be applied at the first OTP programming region 330 to create such an electric field across the first OTP programming region 330 and the second programming region 340. At the same time, a voltage approximately equal to a gate voltage can be applied to the source region 235 and the drain region 240 through the first contact region 316 and the second contact region 318, respectively. Alternatively, the source region 235 and the drain region 240 can be configured to be in a floating state.

During reading of an OTP device 200, a reading voltage can be applied to the first OTP programming region 330, while the second programming region 340 can be maintained in a floating state. The reading voltage can be applied less than the voltage required for the critical electric field so that the reading operation does not inadvertently program, namely disintegrate or "blow" the OTP region 332, the OTP device 200. At the same time, source and drain voltages similar to that applied in operation of the conventional transistor can be applied to the source region 235 and the drain region 240 through the first contact region 316 and the second contact region 318, respectively.

AN EXAMPLE METHOD FOR FABRICATING THE EXEMPLARY OTP DEVICE

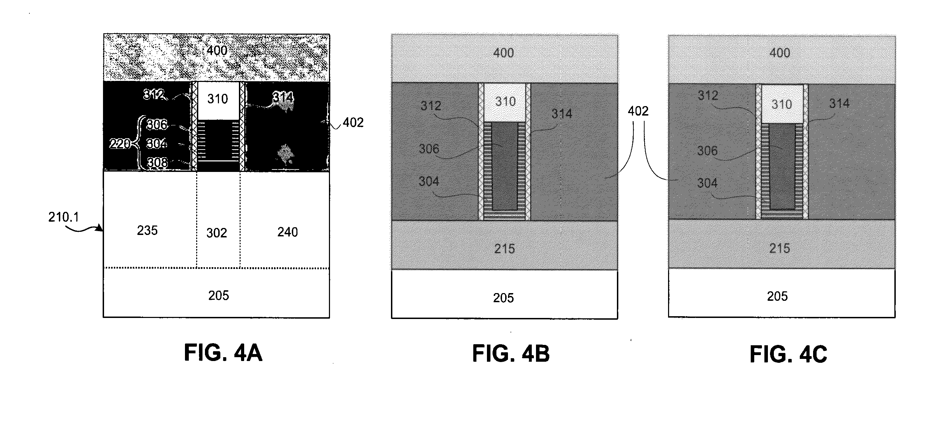

FIGs. 4A - 12A, 4B - 12B, and 4C - 12C illustrate schematic cross-sectional views along lines A-A, B-B, and C-C, respectively, of OTP device 200 (as illustrated in FIGs. 2 and 3A though 3C) at various stages of its fabrication process according to an embodiment.

FIGs. 4A-C illustrate a partially fabricated OTP device 200 after front end of line (FEOL) processing followed by deposition of a middle end of line (MEOL) dielectric region 400 according to an embodiment. The current FEOL processing for fabricating a finFET can be used to form the fin structures 210.1 through 210.r, the STI region 215, the gate structure 220, the optional gate cap region 310, the first spacer region 312, and the second spacer region 314 within a FEOL dielectric region 402 disposed in substantial contact with the fin structure 210.1 as illustrated in FIG. 4A or the STI region 215 as illustrated. In an example, the FEOL dielectric region 402 can be coplanar with the optional gate cap region 310 and can include, for example, oxide, nitride, or any suitable dielectric material. The deposition of the MEOL dielectric region 400 can be performed by depositing a region of oxide, nitride, or any suitable dielectric material using current deposition methods such as, but not limited to, CVD or ALD. The deposited MEOL dielectric region 400 can form substantial contact with top surfaces of the optional gate cap region 310, the first spacer region 312, and the second spacer region 314, and the FEOL dielectric region 402. It should be noted that the FEOL dielectric region 402 and the MEOL dielectric region 400 were not illustrated in FIG. 2 and FIG. 3A - FIG. 3E for the sake of simplicity.

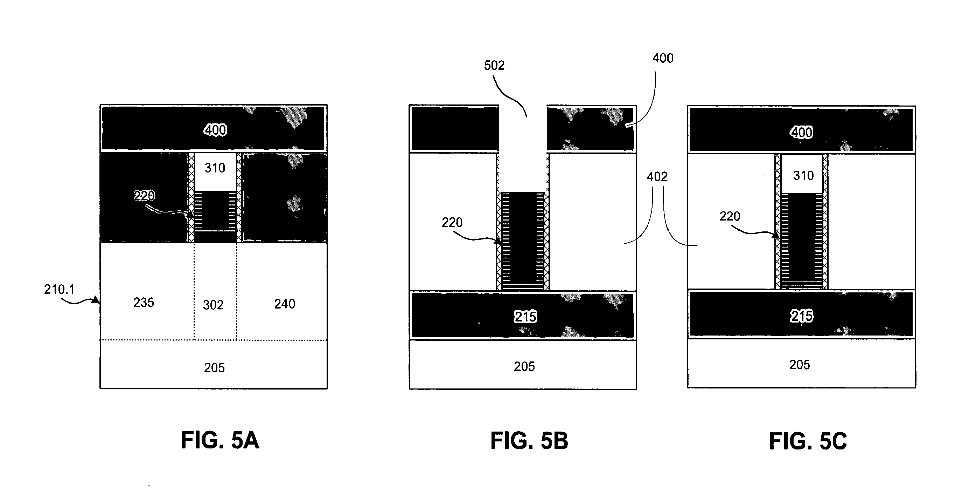

FIGs. 5A-C illustrate a partially fabricated OTP device 200 after formation of a trench 502 on a portion of the gate structure 220 that corresponds to line A-A as illustrated in FIG. 2. Formation of the trench 502 can include defining a trench etch area (not illustrated) in substantial contact with the MEOL dielectric region 400 above the portion of the gate structure 220 using any current patterning method. For example, the patterning of the trench area can be performed by standard photolithography. The patterning of the trench etch area can be followed by any current etching method suitable for etching the materials of the MEOL dielectric region 400 and the optional gate cap region 310 from the patterned trench etch area. For example, a dry etch process such as, but not limited to, reactive ion etching (RIE) can be performed to remove the materials of the MEOL dielectric region 400 and the optional gate cap region 310 for the formation of trench 502.

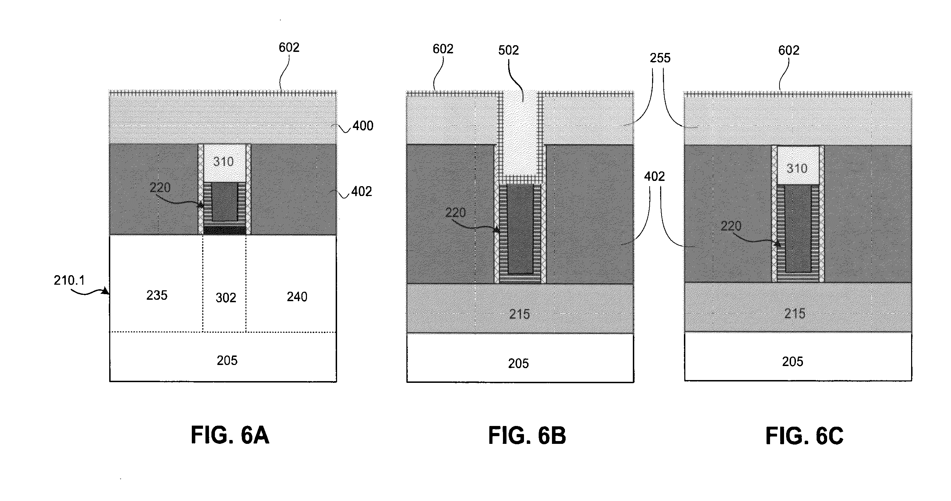

FIGs. 6A-C illustrate a partially fabricated OTP device 200 after coating of sidewalls of the trench 502 according to an embodiment. The coating process can be performed by depositing a dielectric region 602 similar to the OTP region 332. The dielectric region 602 can form a coating in substantial contact with the trench 502 and form a region that is in substantial contact with the MEOL dielectric region 400, as illustrated in FIG. 6A through FIG. 6C. The deposition of the dielectric region 602 can be performed using any deposition process suitable for depositing thin dielectric films such as, but not limited to a CVD process or an ALD process.

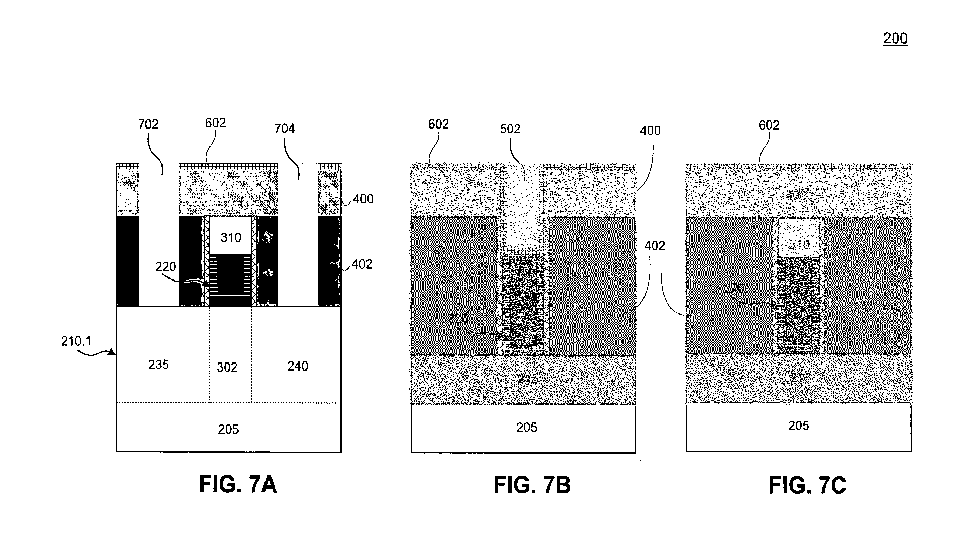

FIGs. 7A-C illustrate a partially fabricated OTP device 200 after formation of a first trench 702 and a second trench 704 in the MEOL dielectric region 400 and the FEOL dielectric region 402. Similar to the trench 502, the first trench 702 and the second trench 704 can be formed by defining trench etch areas (not illustrated) in substantial contact with the MEOL dielectric region 400 followed by etching of the materials of the BEOL dielectric region 400 and the FEOL dielectric region 402 from the patterned trench etch areas.

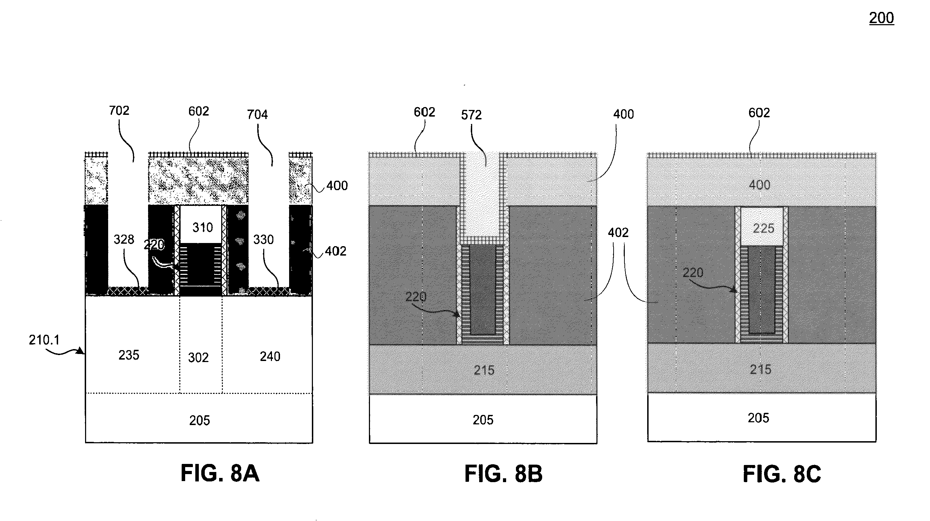

FIGs. 8A-C illustrate a partially fabricated OTP device 200 after formation of the silicide regions 328 and 330 in the trenches 702 and 704, respectively, by any current silicide process. The dielectric region 602 can protect the gate metal from being attacked during the silicidation process.

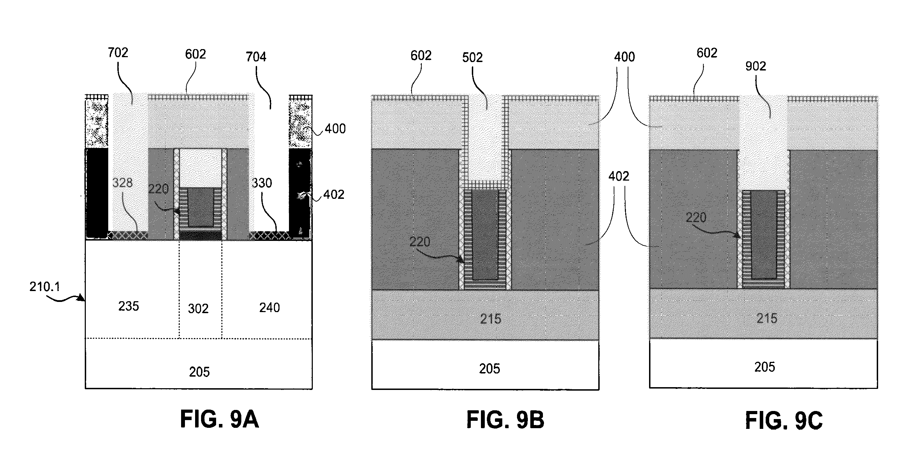

FIGs. 9A-C illustrate a partially fabricated OTP device 200 after formation of a trench 902 on a portion of the gate structure 220 that corresponds to line B-B as illustrated in FIG. 2. Similar to the trench 502, the trench 902 can be formed by defining trench etch areas (not illustrated) in substantial contact with the MEOL dielectric region 400 followed by etching of the materials of the MEOL dielectric region 400 and the optional gate cap region 310 from the patterned trench etch area.

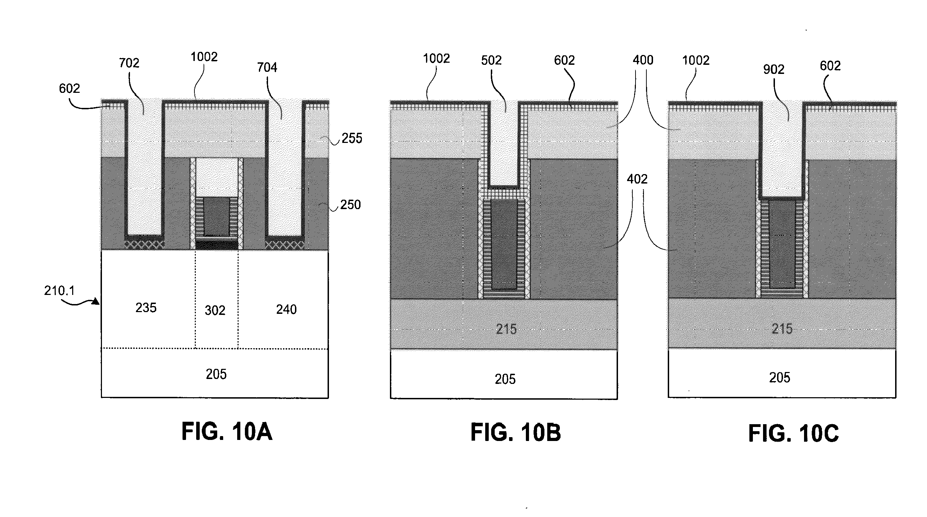

FIGs. 10A-C illustrate a partially fabricated OTP device 200 after deposition of a conductive region 1002 of material similar to the material of the first conductive region 336 as described with reference to FIG. 2 and FIG. 3A through FIG. 3E. The conductive region 1002 can be deposited to form a coating on sidewalls of the trenches 776, 778, 902, respectively. Further, the deposited conductive region 1002 can form a coating in substantial contact with the dielectric region 602. The deposition of conductive region 1002 can be performed using any deposition process suitable for depositing thin conductive films such as, but not limited to a CVD process or an ALD process.

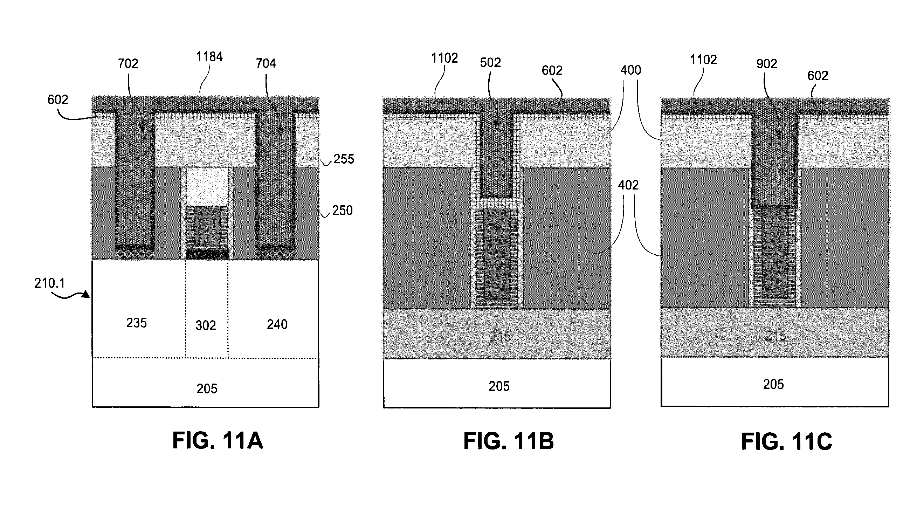

FIGs. 11A-C illustrate a partially fabricated OTP device 200 after filling of the trenches 502, 702, 704, and 902. The filling of the trenches 502, 702, 704, and 902 can include a deposition process. The deposition process can be performed by depositing a conductive region 1102 of conductive material similar to the material of the second conductive region 338, as described with reference to FIG. 2 and FIG. 3A through FIG. 3E. The conductive region 1102 can be deposited such that at least trenches 502, 702, 704, and 902 are filled with the conductive material as illustrated in FIG. 11A through C. The deposition of conductive region 1102 can be performed using any current deposition methods suitable for conductive materials such as, but not limited to a CVD or an ALD process.

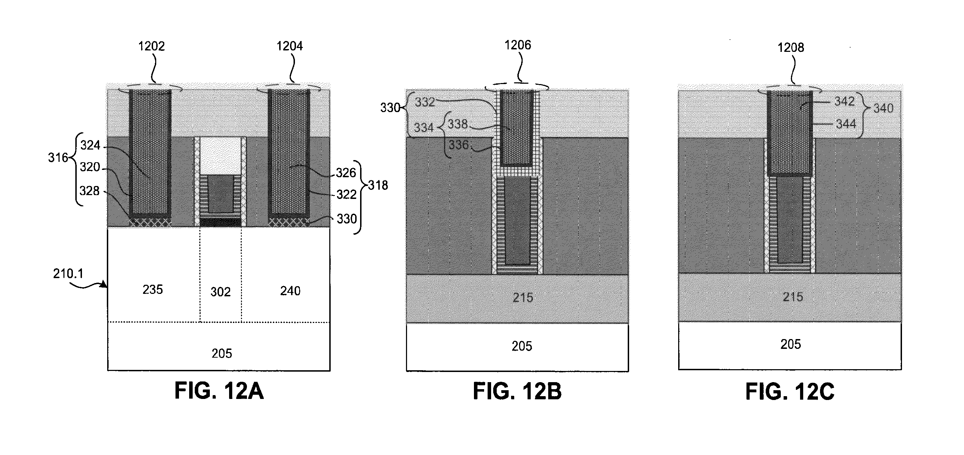

FIGs. 12A-C illustrate a partially fabricated OTP device 200 after performing a chemical mechanical polishing (CMP) process. The CMP process can remove the conductive region 1002 and the conductive region 1102 from any areas except for the trenches 502, 702, 704, and 902 and remove dielectric region 602 from any areas except for the trench 502. This process can yield the first OTP programming region 330, the second programming region 340, and the contact regions 316 and 318 as illustrated in FIG. 2 and FIG. 3A through 3E. During the CMP process, the MEOL dielectric region 400 can act as a polishing stop region. Portions of the regions 602, 1002, and 1102 disposed in substantial contact with the MEOL dielectric region 400 can be polished down such that top surfaces 1202, 1204, 1206, and 1208 of the first OTP programming region 330, the second programming region 340, and the contact regions 316 and 318, respectively, are coplanar with a top surface of the MEOL dielectric region 400.

As apparent from the above discussion, OTP device 200 can be compatible with current integrated circuit (IC) fabrication making it suitable for memory devices integrated into IC systems. This allows fabrication process of OTP device 200 to be incorporated with the fabrication processes of other semiconductor devices on same IC chip.

It should be understood that the various regions illustrated during the example fabrication process of OTP device 200 are not necessarily drawn to scale. In addition, the above description is meant to provide a general overview of select steps involved in forming OTP device 200 illustrated in FIGs. 2 and FIG. 3A through FIG. 3E, and that, in actual practice, more features and/or fabrication steps may be performed additionally or alternatively to that described herein to form OTP device 200, as would be understood by one skilled in the relevant art(s) given the description herein.

EXAMPLE STEPS FOR FABRICATING AN OTP DEVICE ACCORDING TO AN EMBODIMENT

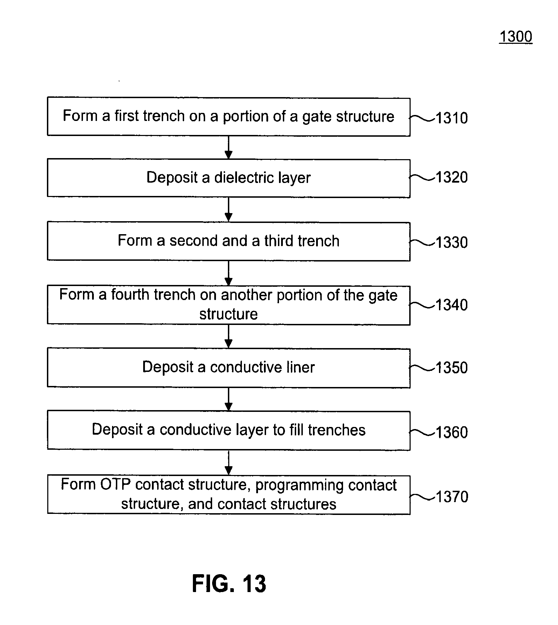

FIG. 13 illustrates a flowchart 1300 for a method of fabricating OTP device 200 as illustrated in FIG. 2 and FIG. 3A through FIG. 3E. Solely for illustrative purposes, the steps illustrated in FIG. 13 will be described with reference to example fabrication process illustrated in FIG. 4A through FIG. 4C and FIG. 12A through FIG. 12C. Steps can be performed in a different order or not performed depending on specific applications.

In step 1310, a first trench is formed on a portion of a gate structure. For example, a first trench such as the trench 502 can be formed on a portion of the gate structure 220 as illustrated in FIG. 5B. The trench 502 can be formed, for example, by a dry etch process such as, but not limited to, reactive ion etching (RIE) that can remove the materials of the MEOL dielectric region 400 and the optional gate cap region 310 from above the portion of the gate structure 220.

In step 1320, a dielectric region is deposited to coat the sidewalls of the first trench. For example, a dielectric region such as the dielectric region 602 of dielectric material can be deposited as illustrated in FIG. 6A through FIG. 6C. The dielectric region 602 can form a coating in substantial contact with the sidewalls of the trench 502 and form a region that is in substantial contact with the BOEL dielectric region 400, as illustrated in FIG. 6A through FIG. 6C. The deposition of the dielectric region 602 can be performed using any deposition process suitable for depositing thin dielectric films such as, but not limited to a CVD process or an ALD process.

In step 1330, a second and a third trench is formed. For example, a second and a third trench similar to the trenches 702 and 704 can be formed in the MEOL dielectric region 400 and the FEOL dielectric region 402, as illustrated in FIG. 7A. The trenches 702 and 704 can each be formed in a similar process as the trench 502.

In step 1340, a fourth trench is formed on another portion of the gate structure. For example, a fourth trench similar to the trench 902 can be formed on another portion of the gate structure 220, as illustrated in FIG. 9C. The trench 902 can be formed in a similar process as the trench 502.

In step 1350, a conductive region is deposited. For example, a conductive region such as the conductive region 1002 of conductive material can be deposited to form a coating in substantial contact with the trenches 702, 704, 902, and in substantial contact with the dielectric region 602, as illustrated in FIG. 10A through FIG. 10C.

In step 1360, a conductive region is deposited. For example, a conductive region such as the conductive region 1102 of conductive material can be deposited to fill the trenches 502, 702, 704, and 902, as illustrated in FIG. 11A through FIG. 11C.

In step 1370, a CMP process is performed. For example, a CMP process similar to that described with reference to FIG. 12A through FIG. 12C can be performed to yield the first OTP programming region 330, the second programming region 340, and the contact regions 316 and 318 as illustrated in FIG. 2 and FIG. 3A through FIG. 3E.

CONCLUSION

It is to be appreciated that the Detailed Description section, and not the Abstract section, is intended to be used to interpret the claims. The Abstract section can set forth one or more, but not all exemplary embodiments, of the present disclosure, and thus, are not intended to limit the present disclosure and the appended claims in any way.

The present disclosure has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

It will be apparent to those skilled in the relevant art(s) that various changes in form and detail can be made therein without departing from the spirit and scope of the present disclosure. Thus, the present disclosure should not be limited by any of the above-described exemplary embodiments, but should be defined only in accordance with the following claims and their equivalents.

**Claims**

1.   A one-time programmable (OTP) device, comprising:

       a first dielectric region in substantial contact with a substrate;
       a gate structure in substantial contact with the first dielectric region;

a first contact region, in substantial contact with the gate structure, configured to be electrically isolated from the gate structure, the first contact region including:

an insulating region, and
a conductive region; and

a second contact region, in substantial contact with the gate structure, configured to be electrically coupled to at least a portion of the gate structure, the second contact region including the conductive region.

2.   The OTP device of claim 1, further comprising:

a fin structure in substantial contact with the substrate, the fin structure comprising a source region and a drain region.

3.   The OTP device of claim 1 or 2, further comprising:

a third contact region arranged to wrap around at least a first portion of the fin structure; and
a fourth contact region arranged to wrap around at least a second portion of the fin structure.

4.   The OTP device of any of claims 2 to 3, wherein the gate structure is between the source region and the drain region and arranged to wrap around at least a portion of the fin structure.

5.   The OTP device of any of claims 2 to 4, wherein the first contact region is in substantial contact with a first region of the gate structure;
wherein the second contact region is in substantial contact with a second region of the gate structure; and
wherein the first and second regions are separated by the fin structure.

6.   The OTP device of any preceding claim, wherein the insulating region is in substantial contact with the gate structure; and
wherein the conductive region is in substantial contact with the insulating region.

7.   The OTP device of any preceding claim, wherein the first contact comprises a cross-section having an outer region and an inner region, wherein the outer region includes the insulating region and the inner region includes the conductive region.

8.   The OTP device of any preceding claim, further comprising:

a second dielectric region in substantial contact with the first dielectric region; and

a third dielectric region in substantial contact with the second dielectric region.

9.   The OTP device of claim 8, wherein the first contact comprises a cross-section having a first side and a second side, the first side being in substantial contact with the gate structure and the second side being in substantial contact with the third dielectric region.

10.   The OTP device of claim 8 or 9, wherein the second contact region comprises a cross-section having a first side and a second side, the first side being in substantial contact with the gate structure and the second side being in substantial contact with the third dielectric region.

11.   The OTP device of any preceding claim, wherein the insulating region comprises a dielectric material.

12.   The OTP device of any preceding claim, wherein the insulating region is configured to disintegrate in response to a first voltage being applied to the first contact and a second voltage applied to the second contact region simultaneously, the second voltage being higher than the first voltage by a threshold value.

13.   A method of fabricating a one-time programmable device, comprising:

forming in substantial contact with a gate structure;
forming a first contact in substantial contact with a first region of the gate structure, the first contact including:

an insulating region, and
the conductive region;

forming a second contact region in substantial contact with a second region of the gate structure, the second contact region including the conductive region.

14.   The method of claim 13, wherein the forming of the first contact comprises:

forming a trench in a first dielectric region and a second dielectric region, the first dielectric region being disposed in substantial contact with the second dielectric region and the second dielectric being disposed in substantial contact with the gate structure;
disposing an insulating region to form an insulating region on sides of the trench;
disposing a first conductive region to form a conductive region in substantial contact with the insulating region; and

disposing a second conductive region to at least fill the lined trench.
disposing a first conductive region to form a conductive region on sides of the trench; and
disposing a second conductive region to at least fill the lined trench.

**15.** A semiconductor device, comprising:

a source region;
a drain region;
a gate structure between the source region and the drain region;
a first contact region in substantial contact with the gate structure and configured to be electrically isolated from the gate structure, the first contact region including:

an insulating region, and
a conductive region; and

a second contact region in substantial contact with the gate structure and configured to be electrically coupled to at least a portion of the gate structure, the second contact region including the conductive region.

**FIG. 1**

**FIG. 2**

EP 2 894 670 A2

**FIG. 3C**

**FIG. 3B**

**FIG. 3A**

**FIG. 3D**

**FIG. 3E**

FIG. 4A

FIG. 4B

FIG. 4C

**FIG. 5A**

**FIG. 5B**

**FIG. 5C**

FIG. 6A   FIG. 6B   FIG. 6C

FIG. 7A          FIG. 7B          FIG. 7C

EP 2 894 670 A2

FIG. 8A  FIG. 8B  FIG. 8C

EP 2 894 670 A2

EP 2 894 670 A2

**FIG. 9A**

**FIG. 9B**

**FIG. 9C**

FIG. 10C

FIG. 10B

FIG. 10A

FIG. 11C

FIG. 11B

FIG. 11A

FIG. 12A

FIG. 12B

FIG. 12C

1300

| Form a first trench on a portion of a gate structure | ~1310 |

| Deposit a dielectric layer | ~1320 |

| Form a second and a third trench | ~1330 |

| Form a fourth trench on another portion of the gate structure | ~1340 |

| Deposit a conductive liner | ~1350 |

| Deposit a conductive layer to fill trenches | ~1360 |

| Form OTP contact structure, programming contact structure, and contact structures | ~1370 |

**FIG. 13**

EP 2 894 670 A2